Europäisches Patentamt

European Patent Office

Office européen des brevets

(19)

(11) Veröffentlichungsnummer : **0 098 587**
**B1**

(12) **EUROPÄISCHE PATENTSCHRIFT**

(45) Veröffentlichungstag der Patentschrift :
**30.12.86**

(21) Anmeldenummer : **83106561.0**

(22) Anmeldetag : **05.07.83**

(51) Int. Cl.⁴ : **H 05 K   5/06**, H 05 K   9/00,
**H 05 K   7/20**, H 05 K 11/02

(54) **Gehäuse für ein Funkgerät.**

(30) Priorität : **08.07.82 DE 3225627**

(43) Veröffentlichungstag der Anmeldung :
**18.01.84 Patentblatt 84/03**

(45) Bekanntmachung des Hinweises auf die Patenterteilung : **30.12.86 Patentblatt 86/52**

(84) Benannte Vertragsstaaten :
**AT BE CH DE FR GB IT LI NL SE**

(56) Entgegenhaltungen :
**GB-A- 1 604 368**
**US-A- 2 964 621**
**US-A- 3 091 736**
**US-A- 4 167 032**
**IBM TECHNICAL DISCLOSURE BULLETIN, Band 17,**
**Nr. 9, Februar 1975, Seite 2712, New York, US, E.W.**
**NEUMANN u.a.: "Conductive gasket"**

(73) Patentinhaber : **Siemens Aktiengesellschaft Berlin**
**und München**
**Wittelsbacherplatz 2**
**D-8000 München 2 (DE)**

(72) Erfinder : **Nothnagel, Gerd, Ing. Grad.**
**Geroltstrasse 36**
**D-8000 München 2 (DE)**

EP 0 098 587 B1

## Beschreibung

Die Erfindung bezieht sich auf ein Gehäuse für ein Funkgerät, das insbesondere für den mobilen Einsatz vorgesehen ist. Ein solches Funkgerät soll in seinem Aufbau klein und leicht, dabei aber stabil sein. Darüber hinaus werden HF- und Staubdichtheit gefordert sowie Service- und Montagefreundlichkeit.

Der Erfindung liegt die Aufgabe zugrunde, ein Gehäuse für ein Funkgerät zu schaffen, das diesen Anforderungen genügt.

Diese Aufgabe wird gemäß der Erfindung gelöst mit einem Gehäuse, bestehend aus einem zylinderförmigen, an seinen Stirnseiten offenen Gehäuseteil, einem wannenförmig ausgebildeten Kühlkörper als Abschluß für die vordere Stirnseite mit Kühlrippen an der Außenseite und einem Hohlraum an der Innenseite sowie aus einem Deckel als Abschluß für die Rückseite, mit sich in Längsrichtung im zylinderförmigen Gehäuseteil erstreckenden Trennwänden zur Bildung von Kammern mit Führungen für Leiterplatten genormter Größe und Baugruppen sowie mit einer den wärmeerzeugende Baugruppen und die interne Verdrahtung enthaltenden Hohlraum des Kühlkörpers abschließenden Rückwand-Leiterplatte, die an ihrer Außenseite die Steckkontaktelemente für die Verbindung der Leiterplatten untereinander und mit den im Kühlkörper angeordneten Baugruppen enthält.

·Vorteilhafte Ausgestaltungen und Weiterbildungen des Erfindungsgegenstandes sind in den Unteransprüchen angegeben.

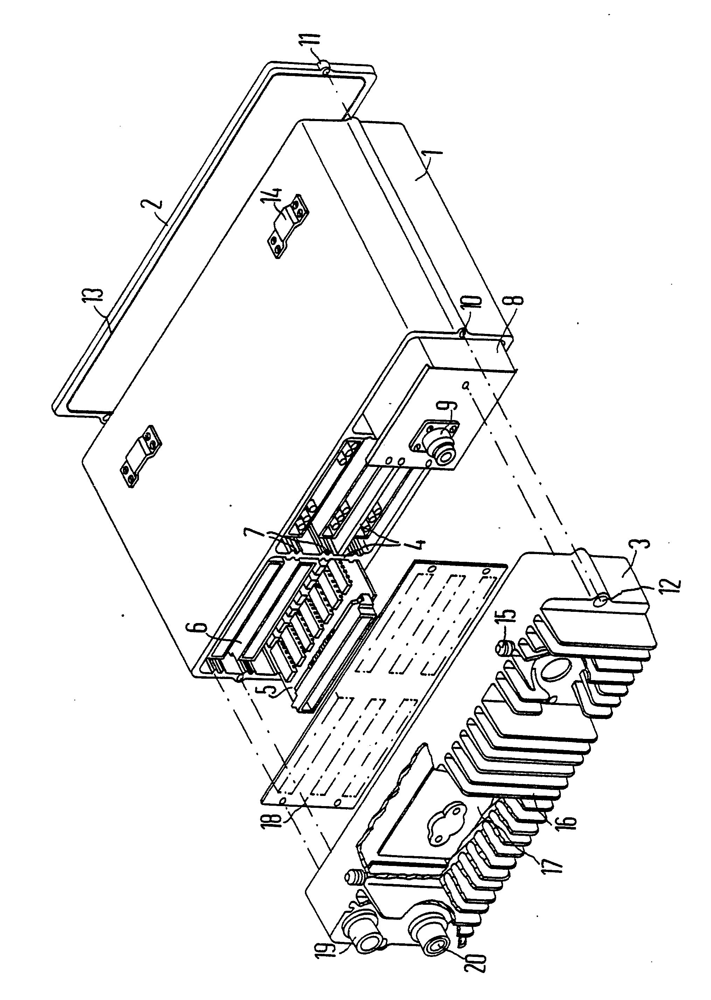

Nachstehend wird die Erfindung anhand eines in der Zeichnung dargestellten Ausführungsbeispieles näher erläutert.

Die Figur zeigt das bestückte Gehäuse in einer perspektivischen Darstellung bei abgenommenen Gehäuseabdeckungen. Das Grundelement des Gehäuses ist ein zylinderförmiger, an seinen Stirnseiten offener Gehäuseteil 1 von rechteckförmigem Querschnitt. Im Inneren sind sich in Längsrichtung erstreckende Trennwände 4 mit Führungen 7 zur Bildung von Kammern vorgesehen. Der Gehäuseteil 1 samt Trennwänden 4 besteht vorzugsweise aus einem Strangpreßprofil. In den Kammern sind, mittels der Trennwände 4 untereinander HF-dicht abgeschirmt, in den betreffenden Führungen 7 Leiterplatten 5 genormter Größe mit Steckkontaktleisten 6 eingesetzt sowie in einer Kammer ein Duplex-Filter 8, das in einem Kühlkörper angeordnet ist.

An dem Gehäuseteil 1 ist an den Schmalseiten außen oder innen eine in Längsrichtung verlaufende Bohrung 10 angeordnet zur Aufnahme von Befestigungselementen für einen Deckel 2 als rückseitiger Abschluß des Gehäuseteils 1 und eines Kühlkörpers 3 als stirnseitiger Abschluß des Gehäuseteils 1. Deckel 2 und Kühlkörper 3, die in entsprechender Lage zu den seitlichen Bohrungen des Gehäuseteils 1 entsprechende Befestigungsbohrungen 11, 12 aufweisen, werden unter Zwischenlage eines metallisierten Dichtungsringes 13 HF- und spritzwasserdicht auf den Gehäuseteil 1 aufgesetzt.

Der Kühlkörper 3, vorzugsweise aus Druckguß bestehend, ist wannenförmig ausgebildet und an der Außenseite mit Kühlrippen 16 versehen. Im wannenförmigen, inneren Bereich sind die wärmeerzeugenden Baugruppen angeordnet. Im aufgeschnittenen Bereich ist die Endstufe 17 sichtbar. Die Wärme wird dabei durch entsprechenden Kontakt der wärmeerzeugenden Bauteile von der Innenseite des Kühlkörpers 3 über die Kühlrippen 16 an die Umgebung abgegeben. Im Kühlkörper 3 sind ferner alle zur Verbindung mit Stromversorgung, Bediengerät und Antenne nötigen Stecker angeordnet. Dabei sind der Stromversorgungsanschluß 19 und der Bediengerätestecker 20 direkt an der Innen- oder Außenseite des Kühlkörpers 3 befestigt, der Antennenstecker 9 am Duplex-Filter 8 ist durch eine Öffnung zur Außenseite des Kühlkörpers 3 herausgeführt.

Abgeschlossen wird der Innenraum des Kühlkörpers 3 mit einer vorzugsweise in Multiplayer-Technik hergestellten Rückwand-Leiterplatte 18, die die für die Verbindung der im Gehäuseteil 1 eingesetzten Leiterplatten 5 untereinander und mit den im Kühlkörper 3 angeordneten Baugruppen notwendigen Verbindungsleitungen und Steckelemente (in der Figur nicht sichtbar) an der Innen- bzw. Außenseite enthält.

Somit sind also alle Elemente oder Baugruppen einschließlich des am Kühlkörper 3 zu befestigenden Duplex-Filters 8, die untereinander verbunden werden müssen, in einem einzigen Körper untergebracht. Der Kühlkörper 3 enthält als kompakte Einheit sowohl Baugruppen als auch die gesamte interne Verdrahtung mit den zugehörigen Verbindungselementen. Ein gegebenenfalls erforderlicher Austausch von Leiterplatten ist in einfacher Weise möglich, da diese nach Abnahme des Deckels 2 von der Rückseite des Gehäuses leicht zugänglich sind. Insofern ist dieser einfache Gehäuseaufbau auch besonders service- und montagefreundlich.

An der obengelegenen Breitseite des Gehäuseteiles 1 sind zwei Laschen 14 angebracht, die der Befestigung des Funkgerätes z. B. im Kofferraum eines Autos in einem dafür vorgesehenen Rahmen dienen. Über zwei am Kühlkörper 3 angebrachte Zentrierbolzen 15 kann das Funkgerät in entsprechend ausgebildeten Federaufnahmen eingeschnappt werden.

## Patentansprüche

1. Gehäuse für ein Funkgerät, gekennzeichnet durch einen zylinderförmigen, an seinen Stirnseiten offenen Gehäuseteil (1), einen wannenförmig ausgebildeten Kühlkörper (3) als Abschluß für die vordere Stirnseite mit Kühlrippen (16) an der Außenseite und einem Hohlraum an der Innenseite sowie einen Deckel (2) als Abschluß für die Rück-seite, ferner durch sich in Längsrichtung im zylinderförmigen Gehäuseteil (1) erstreckende Trennwände (4) zur Bildung von Kammern mit Führungen (7) für Leiterplatten (5) genormter Größe und Baugruppen sowie durch eine den wärmeerzeugende Baugruppen (17) und die interne Verdrahtung enthaltenden Hohlraum des Kühlkörpers (3) abschließende Rückwand-Leiterplatte (18), die an ihrer Außenseite die Steckkontaktelemente für die Verbindung der Leiterplatten (5) untereinander und mit den im Kühlkörper (3) angeordneten Baugruppen (17) enthält.

2. Gehäuse nach Anspruch 1, dadurch gekennzeichnet, daß der zylinderförmige Gehäuseteil (1) aus einem Strangpreßprofil besteht.

3. Gehäuse nach Anspruch 1 oder 2, dadurch gekennzeichnet, daß im Bereich der Anlagefläche von Kühlkörper (3) und Deckel (2) mit dem zylinderförmigen Gehäuseteil (1) ein metallisierter Dichtungsring (13) angeordnet ist.

4. Gehäuse nach einem der Ansprüche 1 bis 3, dadurch gekennzeichnet, daß im Kühlkörper (3) alle Verbindungsstecker, d. h. für Stromversorgung, Bediengerät und Antennen angeordnet sind.

5. Gehäuse nach einem der Ansprüche 1 bis 4, dadurch gekennzeichnet, daß der Kühlkörper (3) aus Druckguß besteht.

6. Gehäuse nach einem der Ansprüche 1 bis 5, dadurch gekennzeichnet, daß die Rückwand-Leiterplatte (18) in Multilayer-Technik aufgebaut ist.

7. Gehäuse nach einem der vorhergehenden Ansprüche, dadurch gekennzeichnet, daß am zylindrischen Gehäuseteil (1) sowie am Kühlkörper (3) und Deckel (2) seitlich außen oder innen sich in Längsrichtung des Gehäuses erstreckende Bohrungen (10, 11, 12) für Befestigungselemente angebracht sind.

8. Gehäuse nach einem der vorhergehenden Ansprüche, dadurch gekennzeichnet, daß an einer Seitenwand des zylinderförmigen Gehäuseteils (1) Einhängelaschen (14) für eine Gerätehalterung angebracht sind.

## Claims

1. A housing for a radio apparatus, characterised by a cylindrical housing component (1) which is open at its end faces, a channel-shaped cooling body (3) with external cooling fins (16) and an internal cavity as a seal for the front end face, and a cover (2) as a seal for the rear, and further by partitions (4) which extends in the longitudinal direction in the cylindrical housing component (1) and serve to form chambers having guides (7) for circuit boards (5) of standard size and assemblies, and by a rear wall circuit board (18) which seals the cavity of the cooling body (3) and carries heat-generating structural components (17) and the internal wiring, and which on its outer side carries the plug-type contact elements for the connection of the circuit boards (5) to one another and to the components (17) which are arranged in the cooling body (3).

2. A housing as claimed in Claim 1, charaterised in that the cylindrical housing component (1) consists of an extruded profile.

3. A housing as claimed in Claim 1 or 2, characterised in that in the region of the contact surface of the cooling body (3), and the cover (2), with the cylindrical housing component (1), there is arranged a metallized sealing ring (13).

4. A housing as claimed in one of Claims 1 to 3, characterised in that all connection pluge, i. e. for the current supply, operating device and antennae, are arranged in the cooling body (3).

5. A housing as claimed in one of Claims 1 to 4, characterised in that the cooling body (3) is a die-casting.

6. A housing as claimed in one of Claims 1 to 5, characterised in that the rear wall circuit board (18) is constructed using multi-layer technology.

7. A housing as claimed in one of the preceding Claims, characterised in that bores (10, 11, 12) for fastening elements, which bores extend in the longitudinal direction of the housing, are arranged on the cylindrical housing component (1) and on the cooling body (3) and cover (2) so as to be laterally external or internal.

8. A housing as claimed in one of the preceding Claims, characterised in that suspension clips (14) for an apparatus holder are arranged on a lateral wall of the cylindrical housing component (1).

## Revendications

1. Boîtier pour appareil de communication par voie hertzienne, caractérisé par un boîtier (1) de forme cylindrique et ouvert sur ses côtés frontaux, un dissipateur de chaleur (3) de la forme d'une cuvette et constituant la fermeture du côté frontal antérieur et pourvu d'ailettes de refroidissement (16) sur le côté extérieur, et une cavité du côté intérieur ainsi qu'un couvercle (2) formant fermeture pour le côté arrière, en outre par des parois de séparation (4) s'étendant dans le sens longitudinal dans l'élément de boîtier (1) de forme cylindrique, en vue de former des chambres avec des guidages (7) pour les plaquettes à circuits imprimés (5) de grandeur normalisée et pour des modules, ainsi que par une plaquette de paroi arrière à circuits imprimés (18) produisant la chaleur et fermant la cavité du dissipateur de chaleur (3) qui contient des modules (17) et le câblage interne, ladite plaquette (18) comportant, sur son côté extérieur, les éléments de contact à enfichage pour la liaison des plaquettes à circuits imprimés (5) entre elles et avec les modules (17) qui sont disposés dans le dissipateur de chaleur (3).

2. Boîtier selon la revendication 1, caractérisé par le fait que l'élément de boîtier (1) de forme cylindrique, est constitué par un profilé extrudé.

3. Boîtier selon la revendication 1 ou 2, caractérisé par le fait que dans la zone intéressant la surface d'application du dissipateur de chaleur (3) et du couvercle (2) avec l'élément de boîtier (1) de forme cylindrique, est prévue une bague d'étanchéité métallisée (13).

4. Boîtier selon l'une des revendications 1 à 3, caractérisé par le fait que dans le dissipateur de chaleur (3) se trouvent disposées toutes les fiches de liaison, c'est-à-dire pour l'alimentation en courant, pour les appareils de fonctionnement et pour les antennes.

5. Boîtier selon l'une des revendications 1 à 4, caractérisé par le fait que le dissipateur de chaleur (3) est constitué par une pièce moulée sous pression.

6. Boîtier selon l'une des revendications 1 à 5, caractérisé par le fait que la plaquette de paroi arrière à circuits imprimés (18) est constituée suivant la technique à couches multiples.

7. Boîtier selon l'une des revendications précédentes, caractérisé par le fait que sur l'élément de boîtier (1) de forme cylindrique, de même que sur le dissipateur de chaleur (3) et sur le couvercle (2) sont prévus, à l'extérieur, ou à l'intérieur et s'étendant dans le sens longitudinal du boîtier, des perçages (10, 11, 12) pour des éléments de fixation.

8. Boîtier selon l'une des revendications précédentes, caractérisé par le fait que sur une paroi latérale de l'élément de boîtier (1) de la forme d'un cylindre, sont montés des colliers d'accrochage (14) pour un support de l'appareil.